# EUROPEAN PATENT SPECIFICATION

(11) **EP 1 886 390 B1**
(45) Date of publication and mention of the grant of the patent: **18.07.2018**
(21) Application number: 06748002.0
(22) Date of filing: 29.05.2006
(51) Int. Cl.: H02G 3/22, F16L 5/08, F16L 5/14, H05K 9/00

(54) **SHIELDED FRAME**
ABGESCHIRMTER RAHMEN
CHASSIS BLINDE

(30) Priority: 30.05.2005 SE 0501233
(43) Date of publication of application: 13.02.2008
(73) Proprietor: Roxtec AB, 371 23 Karlskrona (SE)
(72) Inventor: LUNDBORG, Christer, S-371 32 Karlskrona (SE)
(74) Representative: Karlsson, Leif Gunnar Börje
(86) International application number: PCT/SE2006/050162
(87) International publication number: WO 2006/130104

(56) References cited:
- WO-A1-02/101898
- WO-A1-03/052895
- CA-A- 1 240 386
- DE-A1- 2 932 612
- GB-A- 2 156 169
- GB-A- 2 186 443
- US-A- 4 547 623
- US-A- 4 656 313
- US-A- 4 656 313
- US-A- 5 416 271

## Description

### Technical Field

The present invention concerns a frame for cable entries and/or pipe penetrations. The frame is especially directed to damping of electromagnetic disturbances/EMI (electromagnetic interference).

### Prior Art

A frame for cable entries normally comprises an outer frame, to be received in a wall or other partition. Inside the frame a number of compressible modules, to receive separate cables or pipes, at least one compression unit and one or more stay plates are received. Each module is often formed of two halves that are placed around a cable or pipe. A number of modules are placed inside the frame in several layers or rows above each other and with moveable stay plates between each layer. Furthermore, a compression unit is placed between the frame and the modules in such a way that when the compression unit is expanded the compressible modules will be compressed around the cables or pipes. Frames of this kind are used for sealing in many different environments, such as for cabinets, technical shelters, junction boxes and machines. They are used in different industrial environments, such as automotive, telecom, power generation and distribution, as well as marine and offshore.

The frames may have to seal against fluid, gas, fire, rodents, termites, dust, moisture etc., and may receive cables for electricity, communication, computers etc. or pipes for different gases or liquids such as water, compressed air, hydraulic fluid and cooking gas.

In some installations it is vital to dampen electromagnetic disturbances to protect different electrical or electronic equipments on the inside or outside of the wall, partition etc. receiving the frame. Both disturbances going along the screen of a cable or pipe and RFI (Radio Frequency Interference) are possible to dampen at frames of the type described above. An cable frame addressing the problem of dampening electromagnetic disturbance is discussed, for example, in Canadian Patent Document CA1240-386. However, disturbances going in the conductor(s) of a cable are normally not possible to dampen in a frame of this type. Such disturbances are normally dampened by filters or other means connected to the cables.

Electrical and electronic devices are more or less sensitive to electromagnetic disturbance. Electromagnetic disturbance is electromagnetic radiation which often is emitted by electrical circuits carrying rapidly changing signals, as a by-product of their normal operation, and which causes unwanted signals (interference or noise) to be induced in other circuits. This interrupts, obstructs, or otherwise degrades or limits the effective performance of those other circuits. It can be induced intentionally, as in some forms of electronic warfare, or unintentionally, as a result of spurious emissions and responses, intermodulation products, and the like.

Cables normally have a screen, in the form of a conductive layer, surrounding the cable conductor(s), as a protection against electromagnetic disturbance. In order to be efficient, a cable screen must be able to carry currents generated by electromagnetic disturbance away from the cable, which is achieved by grounding of the cable screen. Proper grounding is critical for obtaining good protection from electromagnetic disturbance, and is a vital part of all electronic and electrical design. There is a mathematical relationship between the efficiency of grounding and the damping achieved.

To dampen radio frequency interference some kind of waveguide (wave trap) and/or a RFI screen should be formed. The waveguide should be grounded.

Today there exist different types of so-called EMC modules. EMC stands for electromagnetic compatibility, i.e. the ability of electrical or electronic devices to function properly in their intended electromagnetic environment. EMC modules are basically standard modules provided with some kind of waveguide and/or a RFI screen and an electrical contact to the cable screens to tap off cable screen borne electromagnetic disturbance/interference to ground. The waveguide is normally some kind of conductive material formed as a pipe, duct or alike, the purpose of which is to act as a trap for RFI. The RFI screen goes normally vertically through the entire EMC module. In one embodiment the RFI screen is made of glass beads coated with silver and placed in a rubber material. Normally, an opening is made in the RFI screen to let a cable or pipe through. The conductive material in contact with the cable screen may be cupper with a tin coating. To have a good connection the conductive material should have a certain length and preferably go 360° around the cable screen. Furthermore, in many installations today a special cover of conductive material has to be placed on or in the compression unit to guarantee protection against RFI and proper grounding of any protruding bolts.

Due to the fact that the cable material outside the cable screen normally is removed before the cable is received inside an EMC module, said module often has to have two different inner diameters, one adapted to a whole cable and the other to the cable screen. In view of the above a person skilled in the art realises that an EMC module is more complicated than a standard module and also that the production costs are higher for an EMC module.

As the unaffected sealing area of EMC modules is shortened compared to standard modules, due to the RFI screen and the conductive material, the sealing capacity of an EMC module is decreased compared to standard modules. This may be of importance in harsh environments.

If tubes or pipes of a non-conductive material or optical fibre cables are received in a frame of the described type a special waveguide has to be formed. Such a waveguide may have the form of a conductive tape wrapped around the pipe, tube or optical fibre cable or a tube of conductive material placed around the pipe, tube or optical fibre cable. The waveguide is normally grounded to the frame.

In many military applications, at oilrigs, in hospitals, on board airplanes, on board ships, in different types of vehicles, in some industries and so on there may be certain areas that are more sensitive to disturbances, i.e. it is very grave if these areas are knocked out. Such areas need a more efficient damping than other areas. In many instances it is also desirable to dampen equipment on the inside of the frame to hinder espionage or other unwanted surveillance.

The damping effect is measured in dB, for instance according to the standard EN 50 147-1: 1996§5.2.2. The damping effect is reduced considerable when cables are received compared to frames having no cables. Simply put, electrically conductive materials, such as cables, act as antennas, i.e. they both pick up and transmit electric fields to a lesser or greater extent.

There exist a number of equipments giving some damping of electromagnetic disturbances. The damping effect is in many cases increased by a relatively complex set of modified components and handling steps. However, by the known equipments it is hard to achieve a damping exceeding about 40 to 60 dB, when cables are received. However, for sensitive areas the damping should be at least 60 dB or preferably more.

### Summary of the Invention

One object of the present invention is to prevent unwanted electromagnetic fields, such as radio waves, from passing the frame in any direction, and to pick up unwanted electromagnetic energy carried by currents in the cable screens and shunt them to ground.

A further object is that standard components should be used in as large extent as possible. Which is beneficial regarding installation, manufacture, stock keeping etc.

Still a further object is to simplify the installation by avoiding the need of complex components.

According to the present invention a frame for cable entries or pipe penetrations is placed in a wall or other partition forming an opening through the wall or other partition. The frame receives compressible modules surrounding each cable or pipe received in the frame. A barrier of modules is placed together with a compression unit at one end of the frame to form a seal. Furthermore, a layer of conductive material is placed inside the frame adjacent the barrier of modules and compression unit.

The layer of conductive material may be placed in a void inside the frame formed between two barriers of modules etc. at each end of the frame or one barrier of modules etc. at one end and a cover at the other end of the frame. The layer of conductive material may be formed of metal threads placed to form different structures. Such structures are for instance an amorphous bunch, interwoven threads, nets, pads and honeycomb structures. The layer of conductive material may also be formed by means of needle-felt mats. The frame, modules, compression units etc. are standard components well known to a person skilled in the art. The layer of conductive material is grounded and is placed in electrical contact with the cable screen of each cable received in the frame. In testing such an arrangement has shown a damping in the order of around 100 dB or more, with cables received in the frame. The ability to dampen the electromagnetic disturbances is also depending on the form of the cable screen. If cables having low quality screens are used the possibility to dampen electromagnetic disturbances is reduced.

The thickness of the layer of the conductive material is preferably chosen depending on the thickness of the cable or cables and the desired amount of damping. The threads may be made of any suitable conductive material that can sustain a possible harsh environment. In one embodiment cupper threads coated with tin was used. The amorphous bunch of threads is in one embodiment steel wool, made of threads of stainless steel. It is also possible to mix threads of different conductive materials. In other embodiments pads formed of one long thread or needle-felt mats are used.

Irrespective of which material that is used and in which form it is placed the layer of conductive material must be placed in safe connection with the cable screens and be grounded in a safe way.

A person skilled in the art realises that the exact form of the modules, compression units and the frame is of no importance for the invention as such. The present invention may be used both with different types of standard modules and EMC modules. By using standard modules the protection against harsh environments may be increased. Normally, no cover of conductive material is needed over the compression unit at a frame according to the present invention.

Further objects and advantages will be obvious for a person skilled in the art when reading the detailed description below.

### Brief Description of the Drawings

The invention will be described further below, as a way of example and with reference to the enclosed drawings. In the drawings:
Fig. 1 is a perspective view of one example of a frame according to the present invention;
Fig. 2 is a front view of the frame of Fig. 1;
Fig. 3 is a sectional view along the lines A-A of Fig. 2, but with one cable received;
Fig. 4 is a cable set up to be received in shielded form in the frame;
Fig. 5 is a perspective view of one further example of a frame according to the present invention;
Fig. 6 is a sectional view corresponding to Fig. 3 of the frame of Fig. 5;
Fig. 7 is a schematic view of one example of a part of the frame according to the present invention; and
Fig. 8 is a schematic view of a further example of a part of the frame according to the present invention.

### Detailed Description of Preferred Embodiments

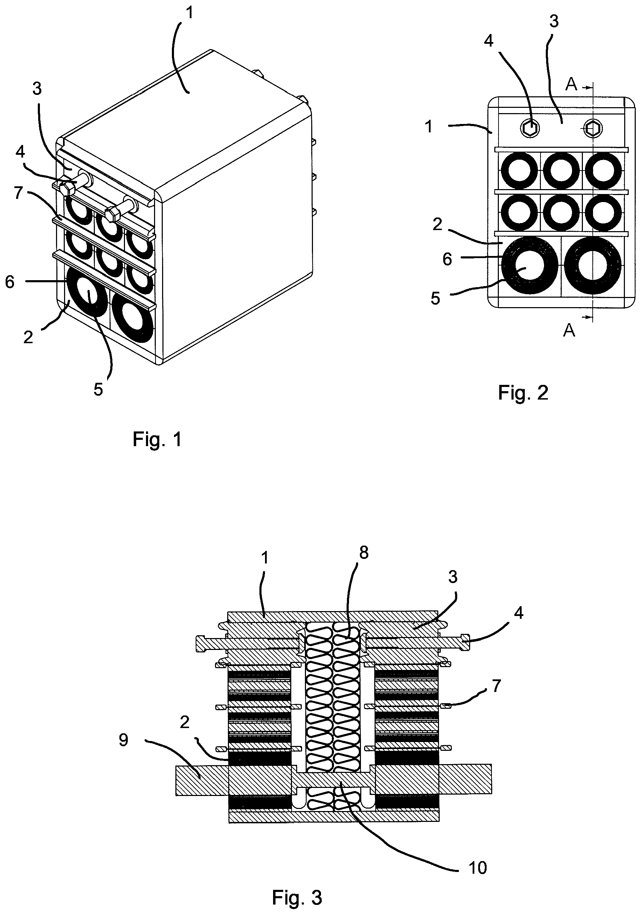

In Figs. 1 to 3 of the drawings one example of a frame 1 is shown, which frame is to be received in a wall or other partition (not shown). Inside the frame 1 a number of modules 2 are received at each end of the frame 1, which modules 2 are made of an elastic material. At least one compression unit 3, here in the form of a wedge, is arranged in connection with the modules 2 at each end of the frame 1 to compress the modules 2. By the compression exerted by the wedge by means of screws 4 and a stay plate 7 the modules 2 will be compressed and give a tight seal, as is well known by a person skilled in the art.

A person skilled in the art realises that the exact design of the frame, modules, stay plates and compression unit is not critical and that the number of modules, compression units and stay plates received in the frame may vary. Thus, many different types of frames, modules, stay plates and compression units may be used.

In the shown embodiment each module 2 is formed of two halves brought together and showing a central blind 5 and a number of peelable sheets 6. Even if standard modules are indicated in the drawings, a person skilled in the art realises that different types of EMC modules may also be used.

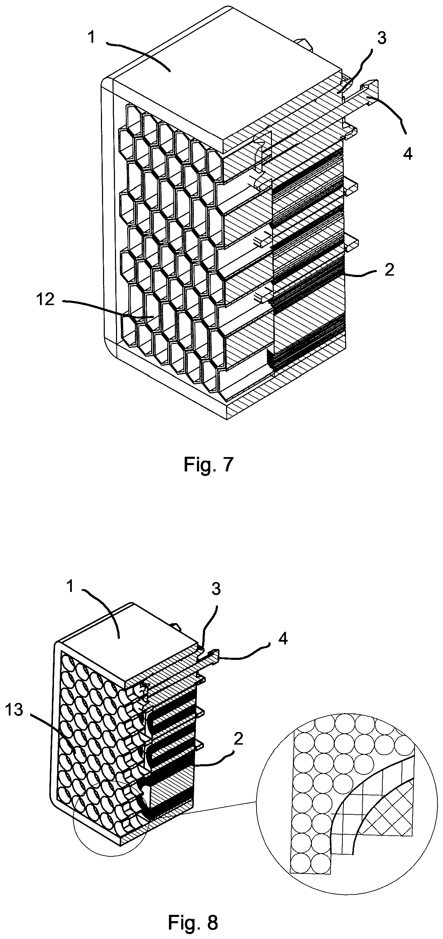

Between the modules 2 and compression units 3 at each end of the frame a void is formed. Said void is filled with a layer 8 of interwoven metal threads, as indicated in Fig. 3, or metal threads placed in an amorphous bunch. The metal threads may be made of any conductive material. In one embodiment steel wool is used. In other embodiments the layer 8 of conductive material has the form of a honeycomb structure 12, several intermeshed nets 13 etc. Examples of a honeycomb structure 12 and intermeshed nets are indicated in Figs. 7 and 8, respectively. If nets 13 or honeycomb structures 12 are used an opening is formed for each cable or pipe in the nets 13 or honeycomb structure 12, before receiving a cable 9 or pipe. In still other embodiments pads of one or more metal threads are formed. Such pads may be formed in that one thread is wound around a core. After suitable winding the core is removed and the formed coil is flattened into a pad. As a pad formed in this way will be rather elastic it may be placed with a press fit in the frame 1. In still a further embodiment the conductive material has the form of needle-felt mat, which needle-felt is made of a suitable conductive material. If a lose bunch of threads is used it is up to the person making the installation to see to it that enough conductive material is placed inside the frame. However, by using pads or mats of standardized size it does not have to be left to the skill of the person making the installation to see that a proper amount of conductive material is inserted. Normally the pads are slightly oversized to guarantee contact with the cables or pipes.

Before a cable 9 is placed in the frame the outer shield of the cable 9 is taken away to expose a cable screen 10. The length of the exposed cable screen 10 is adapted to the length of the void, i.e. the distance between the barriers of modules 2 and wedges 3 at each end of the frame 1. More precisely the length of the exposed cable screen 10 is adapted to the thickness of the layer 8 of conductive material. Hereby, the cable screen 10 will come into contact with the layer 8 of metal threads inside the frame 1. The layer 8 of metal threads and thus the exposed cable screens 10 are grounded to the frame. The size of the area of contact between the cable screen 10 and the layer 8 of conductive material influences the damping effect.

Grounding of the frame 1 may be accomplished in many different ways. On board ships and in many other installations the grounding is made directly in the wall or other partition receiving the frame 1. If necessary the frame may be provided with a contact for connection to earth. Normally, no special cover over the compression unit 3 is needed for RFI protection.

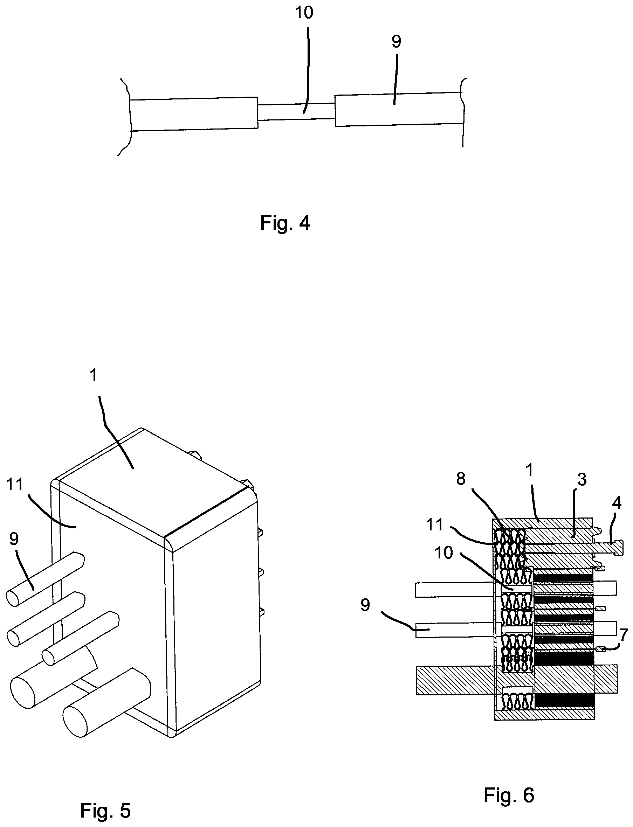

In one embodiment only one barrier of modules 2, a compression unit 3 and stay plates 7 is placed at one end of the frame 1. In the other end of the frame 1 only a cover 11 is positioned to keep the layer 8 of conductive material in place. Frames 1 with only one barrier of modules 2 etc. are primarily intended for installations where it is only a harsh environment on one side of the frame 1. The cover 11 may have many different forms; it may be a plate, a net, a rubber cloth or foil, pins and/or threads attached to the frame. In Figs. 5 and 6 an example with a plate 11 as cover is indicated.

In one installation example steel wool was first placed at the bottom of the frame 1, up to a level corresponding to half a module 2. Then a cable 9 was placed in corresponding lower module halves at each end of the frame 1, with the cable screen 10 exposed in the area between the module halves. Then the upper halves of the modules 2 were placed on top of the lower halves. Where after, further steel wool was placed on top of the steel wool at the bottom of the frame 1 and surrounding and in contact with the exposed cable screen 10. Normally, all cables 9 in one row on one level are installed simultaneous and the steel wool is placed in contact with and surrounding all cables 9. Finally a stay plate 7 was placed on top of the modules 2. These steps were then repeated until the rows of modules 2 at each end were complete and a compression unit 3 had been placed in each barrier and the void between the barriers of modules 2 etc. had been filled with steel wool. The steel wool forming the layer 8 of conductive material was placed in extended and safe contact with the outer frame 1 and with the exposed cable screen 10 of each cable 9.

When using pads of conductive material the installation is made roughly in the same way as indicated above. Thus, first one or more pads are placed on the bottom of the frame 1, up to a level corresponding to half a module 2. Then the cables or pipes are normally placed in the module half or halves, where after one or more upper module halves are placed on the lower module halves. New layers of pads are then placed above the cable or pipes. This is then repeated together with possible placing of partitions, as indicated above, until the space of the frame 1 is filled. If the cables or pipes are relatively thin the flexibility of the pads may be enough to fill out the available space. However, for thicker cables and particularly thicker pipes special side pads may be placed between the frame, the other layers of pads, the pipes, and/or the cables.

## Claims

1. Frame (1) for cable entries or pipe penetrations receiving compressible modules (2) surrounding each cable (9) or pipe received in the frame (1), which frame (1) is placed in a wall or other partition forming an opening through the wall or other partition, whereby a barrier of modules (2) are placed together with at least one compression unit (3) at one end of the frame (1) to form a seal, **characterized in that** a layer (8) of conductive material is placed adjacent the barrier of modules (2) inside the frame (1) and that the layer (8) of conductive material is formed of interwoven threads, nets (13), pads, honeycomb structures (12) or needle-felt mats.

2. The frame (1) of claim 1, **characterized in that** a barrier of modules (2) comprising at least one compression unit (3) is placed at each end of the frame (1) and that the layer (8) of conductive material is placed in a void formed between the barriers of modules (2) at each end of the frame (1).

3. The frame (1) of claim 1, **characterized in that** a cover (11) is placed at the other end of the frame (1) and that the layer (8) of conductive material is placed inside the frame (1) between the barrier of modules (2), comprising at least one compression unit (3), and the cover (11).

4. The frame (1) of claim 1, **characterized in that** the conductive material is steel wool or other amorphous bunch of metal threads.

5. The frame (1) of claim 1, **characterized in that** the conductive material is placed in a honeycomb structure (12) .

6. The frame (1) of claim 1, **characterized in that** the conductive material has the form of several intermeshed nets (13).

7. The frame (1) of claim 1, **characterized in that** the conductive material is grounded.

8. The frame (1) of claim 1, **characterized in that** the modules are EMC modules.

9. The frame (1) of claim 1, **characterized in that** the modules are standard modules.

10. The frame (1) of claim 1, **characterized in that** cables (9) are received inside the modules (2) and that a cable screen (10) of each cable (9) is exposed in the area of the layer (8) of conductive material and is brought into contact with the conductive material.

11. The frame (1) of claim 1, **characterized in that** the layer (8) of conductive material is brought into contact with the frame (1).

12. The frame (1) of claim 1, **characterized in that** pipes are received inside the modules (2) of the frame (1).

13. The frame (1) of claim 1, **characterized in that** if pipes or cables not including parts of conductive material are used, the parts of said pipes or cables are provided with conductive material in the area of the layer (8) of conductive material inside the frame (1) or other type of wave guide.

## Patentansprüche

1. Rahmen (1) für Kabeleinführungen oder Rohrdurchführungen, der komprimierbare Module (2) aufnimmt, die jedes in dem Rahmen (1) aufgenommene Kabel (9) oder Rohr umgeben, wobei der in einer Wand oder einer anderen Trennung angeordnete Rahmen (1) eine Öffnung durch die Wand oder die andere Trennung bildet, wobei eine Barriere aus Modulen (2) zusammen mit mindestens einer Kompressionseinheit (3) an einem Ende des Rahmens (1) angeordnet ist, um eine Dichtung zu bilden, **dadurch gekennzeichnet, dass** eine Schicht (8) aus leitendem Material angrenzend an die Barriere aus Modulen (2) innerhalb des Rahmens (1) angeordnet ist und dass die Schicht (8) aus leitendem Material aus verwobenen Fasern, Netzen (13), Kissen, Wabenstrukturen (12) oder Nadelfilzmatten geformt ist.

2. Rahmen (1) nach Anspruch 1, **dadurch gekennzeichnet, dass** an jedem Ende des Rahmens (1) eine Barriere aus Modulen (2), die zumindest eine Kompressionseinheit (3) umfasst, angeordnet ist und dass die Schicht (8) aus leitfähigem Material in einem Hohlraum zwischen den Barrieren aus Modulen (2) an jedem Ende des Rahmens (1) angeordnet ist.

3. Rahmen (1) nach Anspruch 1, **dadurch gekennzeichnet, dass** an dem anderen Ende des Rahmens (1) eine Abdeckung (11) angeordnet ist und dass die Schicht (8) aus leitfähigem Material innerhalb des Rahmens (1) zwischen der Barriere aus Modulen (2), die mindestens eine Kompressionseinheit (3) umfasst, und der Abdeckung (11) angeordnet ist.

4. Rahmen (1) nach Anspruch 1, **dadurch gekennzeichnet, dass** das leitende Material Stahlwolle oder ein anderes amorphes Bündel von Metallfasern ist.

5. Rahmen (1) nach Anspruch 1, **dadurch gekennzeichnet, dass** das leitfähige Material in einer Wabenstruktur (12) angeordnet ist.

6. Rahmen (1) nach Anspruch 1, **dadurch gekennzeichnet, dass** das leitfähige Material die Form mehrerer ineinandergreifender Netze (13) hat.

7. Rahmen (1) nach Anspruch 1, **dadurch gekennzeichnet, dass** das leitfähige Material geerdet ist.

8. Rahmen (1) nach Anspruch 1, **dadurch gekennzeichnet, dass** die Module EMV-Module sind.

9. Rahmen (1) nach Anspruch 1, **dadurch gekennzeichnet, dass** die Module Standardmodule sind.

10. Rahmen (1) nach Anspruch 1, **dadurch gekennzeichnet, dass** Kabel (9) innerhalb der Module (2) aufgenommen sind und dass ein Kabel-Screen (10) jedes Kabels (9) im Bereich der Schicht (8) aus leitfähigem Material freiliegt und mit dem leitfähigen Material in Kontakt gebracht ist.

11. Rahmen (1) nach Anspruch 1, **dadurch gekennzeichnet, dass** die Schicht (8) aus leitfähigem Material mit dem Rahmen (1) in Kontakt gebracht ist.

12. Rahmen (1) nach Anspruch 1, **dadurch gekennzeichnet, dass** Rohre innerhalb der Module (2) des Rahmens (1) aufgenommen sind.

13. Rahmen (1) nach Anspruch 1, **dadurch gekennzeichnet, dass** bei Verwendung von Rohren oder Kabeln, die keine Teile aus leitfähigem Material enthalten, die Teile der Rohre oder Kabel im Bereich der Schicht (8) aus leitfähigem Material innerhalb des Rahmens (1) mit leitfähigem Material oder einer anderen Art von Wellenleiter versehen sind.

## Revendications

1. Châssis (1) pour entrées de câble ou pénétrations de tuyau recevant des modules compressibles (2) entourant chaque câble (9) ou tuyau reçu dans le châssis (1), lequel châssis (1) est placé sur une paroi ou autre cloison formant une ouverture à travers la paroi ou autre cloison, moyennant quoi une barrière de modules (2) sont placés ensemble avec au moins une unité de compression (3) à une extrémité du châssis (1) pour former un joint, **caractérisé en ce qu'**une couche (8) de matériau conducteur est placée de manière adjacente à la barrière de modules (2) à l'intérieur du châssis (1) et **en ce que** la couche (8) de matériau conducteur est formée de fils entremêlés, de filets (13), de tampons, de structures en nid d'abeille (12) ou de tapis de feutre aiguilleté.

2. Châssis (1) selon la revendication 1, **caractérisé en ce qu'**une barrière de modules (2) comprenant au moins une unité de compression (3) est placée à chaque extrémité du châssis (1) et **en ce que** la couche (8) de matériau conducteur est placée dans un vide formé entre les barrières de modules (2) à chaque extrémité du châssis (1).

3. Châssis (1) selon la revendication 1, **caractérisé en ce qu'**un couvercle (11) est placé à l'autre extrémité du châssis (1) et **en ce que** la couche (8) de matériau conducteur est placée à l'intérieur du châssis (1) entre la barrière de modules (2), comprenant au moins une unité de compression (3), et le couvercle (11) .

4. Châssis (1) selon la revendication 1, **caractérisé en ce que** le matériau conducteur est de la paille de fer ou une autre bande amorphe de fils métalliques.

5. Châssis (1) selon la revendication 1, **caractérisé en ce que** le matériau conducteur est placé dans une structure en nid d'abeille (12).

6. Châssis (1) selon la revendication 1, **caractérisé en ce que** le matériau conducteur a la forme de plusieurs filets entrelacés (13).

7. Châssis (1) selon la revendication 1, **caractérisé en ce que** le matériau conducteur est mis à la terre.

8. Châssis (1) selon la revendication 1, **caractérisé en ce que** les modules sont des modules EMC.

9. Châssis (1) selon la revendication 1, **caractérisé en ce que** les modules sont des modules standard.

10. Châssis (1) selon la revendication 1, **caractérisé en ce que** des câbles (9) sont reçus à l'intérieur des modules (2) et **en ce qu'**un blindage de câble (10) de chaque câble (9) est exposé dans la zone de la couche (8) de matériau conducteur et est amené en contact avec le matériau conducteur (1).

11. Châssis (1) selon la revendication 1, **caractérisé en ce que** la couche (8) de matériau conducteur est amenée en contact avec le châssis (1).

12. Châssis (1) selon la revendication 1, **caractérisé en ce que** des tuyaux sont reçus à l'intérieur des modules (2) du châssis (1).

13. Châssis (1) selon la revendication 1, **caractérisé en ce que** si des tuyaux ou des câbles ne comprenant pas de parties de matériau conducteur sont utilisés, les parties desdits tuyaux ou câbles sont dotés de matériau conducteur dans la zone de la couche (8) de matériau conducteur à l'intérieur du châssis (1) ou autre type de guide d'onde.
